# EUROPÄISCHE PATENTANMELDUNG

(11) **EP 1 622 279 A2**
(43) Veröffentlichungstag der Anmeldung: **01.02.2006**
(21) Anmeldenummer: 05104715.7
(22) Anmeldetag: 01.06.2005
(51) Int. Cl.: H04B 1/26

(54) **Doppel-Superheterodynempfänger**

(30) Priorität: 31.07.2004 DE 102004037249
(71) Anmelder: ROBERT BOSCH GMBH, 70442 Stuttgart (DE)
(72) Erfinder: Grun, Daniel, 31135, Hildesheim (DE); Schnitzer, Reiner, 72764, Reutlingen (DE); Geyer, Michael, 72770, Reutlingen (DE); Bloemer, Kerstin, 38118, Braunschweig (DE)

(57) **Zusammenfassung**

Doppel-Superheterodynempfänger, der ein Empfangsfilter, einen ersten Mischer, ein erstes Zwischenfrequenzfilter, einen zweiten Mischer und ein zweites Zwischenfrequenzfilter aufweist, wobei der zweite Mischer ein Spiegelunterdrückungsmischer ist und mindestens das erste Zwischenfrequenzfilter und der Spiegelunterdrückungsmischer gemeinsam auf einem Chip monolithisch integriert sind.

## Beschreibung

Die vorliegende Erfindung betrifft einen Doppel-Superheterodynempfänger, der ein Empfangsfilter, einen ersten Mischer, ein erstes Zwischenfrequenzfilter, einen zweiten Mischer und ein zweites Zwischenfrequenzfilter aufweist, wobei der zweite Mischer ein Spiegelunterdrückungsmischer ist und mindestens das erste Zwischenfrequenzfilter und der Spiegelunterdrückungsmischer gemeinsam auf einem Chip monolithisch integriert sind.

### Stand der Technik

Aus dem Buch "RF microelectronics" von Behzad Razavi, erschienen 1998 bei Prentice Hall (ISBN 0-13-887571-5) ist in Kapitel 5.2.3 auf der Seite 138 und ff. die Funktionsweise eines Spiegelunterdrückungsmischers bekannt, wobei verschiedene Ausführungsformen, so beispielsweise die Hartley Architektur, die Weaver Architektur sowie die Ausführung eines Spiegelunterdrückungsmischers mittels Digitaltechnik beschrieben sind.

Nachteilig bei Spiegelunterdrückungsmischem ist, dass zur Unterdrückung der Spiegelfrequenz die beiden verwendeten Mischer möglichst identische Eigenschaften und identischen Aufbau besitzen sollten. Weiterhin müssen die den Mischern zugeführten Signale hohen Anforderungen bezüglich ihrer Amplituden- und Phasenverhältnisse genügen. Bereits geringe Abweichungen im elektrischen Verhalten der beiden im Spiegelunterdrückungsmischer verwendeten Mischern oder geringe Abweichungen der zugeführten Signale von den Anforderungen bezüglich der Amplituden- und Phasenverhältnisse führen zu einer beträchtlichen Dämpfungseinbuße der Spiegelfrequenzsignale.

### Kern und Vorteile der Erfindung

Der Kern der vorliegenden Erfindung ist es, einen Doppel-Superheterodynempfänger anzugeben, der ein erstes Zwischenfrequenzfilter sowie einen Spiegelunterdrückungsmischer aufweist, wobei das vor dem Spiegelunterdrückungsmischer vorgeschaltete Zwischenfrequenzfilter sowie der Spiegelunterdrückungsmischer derart ausgeführt sind, dass eine möglichst hohe Störfestigkeit des Empfängers gegen Störeinstrahlung auf Verbindungsleitungen sowie eine hohe Temperaturstabilität der Gesamtschaltung erreicht wird. Erfindungsgemäß wird dieses durch die Merkmale des unabhängigen Anspruchs gelöst. Vorteilhafte Weiterbildungen und Ausgestaltungen ergeben sich aus den Unteransprüchen.

Vorteilhafterweise ist das erste Zwischenfrequenzfilter ein monolithisch integriertes LC-Filter. Durch die Ausführung des ersten Zwischenfrequenzfilters als monolithisch integriertes LC-Filter ist es möglich, dieses Filter gemeinsam mit dem Spiegelunterdrückungsmischer auf dem gleichen Substrat herzustellen, wodurch die Herstellungskosten für das Filter wesentlich geringer werden, sowie der Bauraum geringer gestaltet werden kann.

Weiterhin ist es vorteilhaft, dass das erste Zwischenfrequenzfilter so dimensioniert ist, dass die Dämpfung bei der Frequenz des dem Spiegelunterdrückungsmischer zugefiihrten Nutzsignals möglichst gering und dass die Dämpfung bei der Frequenz des dem Spiegelunterdrückungsmischer zugeführten Spiegelsignals möglichst hoch ist. Hierdurch wird erreicht, dass wenn die beiden Mischer des Spiegelunterdrückungsmischers nicht identisch ausgeführt sind oder die den Mischern zugeführten Signale den hohen Anforderungen bezüglich ihrer Amplituden- und Phasenverhältnisse nicht genügen die zu unterdrückende Spiegelfrequenz durch das vorgeschaltete Zwischenfrequenzfilter in der Amplitude stark gedämpft wird und somit auch bei nicht exakt identischen elektrischen Eigenschaften der beiden Mischer oder geringen Abweichungen der zugeführten Signale von den Anforderungen bezüglich der Amplituden- und Phasenverhältnisse eine hohe Spiegelunterdrückung erreicht wird, ohne dass das Nutzsignal durch das Zwischenfrequenzfilter allzu sehr gedämpft wird.

Durch die gemeinsame Integration des ersten Zwischenfrequenzfilters und des Spiegelunterdrückungsmischers ist es möglich, beide Komponenten eng benachbart auszuführen, so dass die Verbindungsleitungen sehr kurz sind, da die Bondverbindungen zu den Pins, die alternativ zwischen diesen beiden Komponenten vorzusehen wären, entfallen und hiermit die Möglichkeit von Störeinstreuungen verringert wird sowie parasitäre Effekte deutlich reduziert werden. Weiterhin werden dadurch bei differentieller Leitungsführung 4 Pins am IC eingespart, wodurch es möglich ist, die Impedanzen der aufeinanderfolgenden Stufen optimal aufeinander abzustimmen. Durch die gemeinsame Integration auf dem gleichen Substrat ist es weiterhin möglich, eine höhere Temperaturstabilität zu erreichen, da sowohl das Zwischenfrequenzfilter als auch der Spiegelunterdrückungsmischer in etwa bei den gleichen Temperaturen betrieben werden, so dass eine mögliche Temperaturdrift zwischen den beiden Bauelementen verhindert werden kann. Durch die kleinere Bauform, die sich durch die Mitintegration des Zwischenfrequenzfilters mit dem Spiegelunterdrückungsmischer ergibt, ist es weiterhin möglich, den Doppel-Superheterodynempfänger universell in Endgeräten einbauen zu können sowie den Empfänger wesentlich kostengünstiger zu realisieren.

### Zeichnungen

Nachfolgend wird ein Ausführungsbeispiel der Erfindung anhand von Zeichnungen erläutert. Es zeigen
- Figur 1: ein schematisches Blockschaltbild einer Ausführungsform der erfindungsgemäßen Vorrichtung und
- Figur 2: mehrere Frequenzspektren zur Darstellung der Funktionsweise der erfindungsgemäßen Vorrichtung.

### Beschreibung des Ausführungsbeispiels

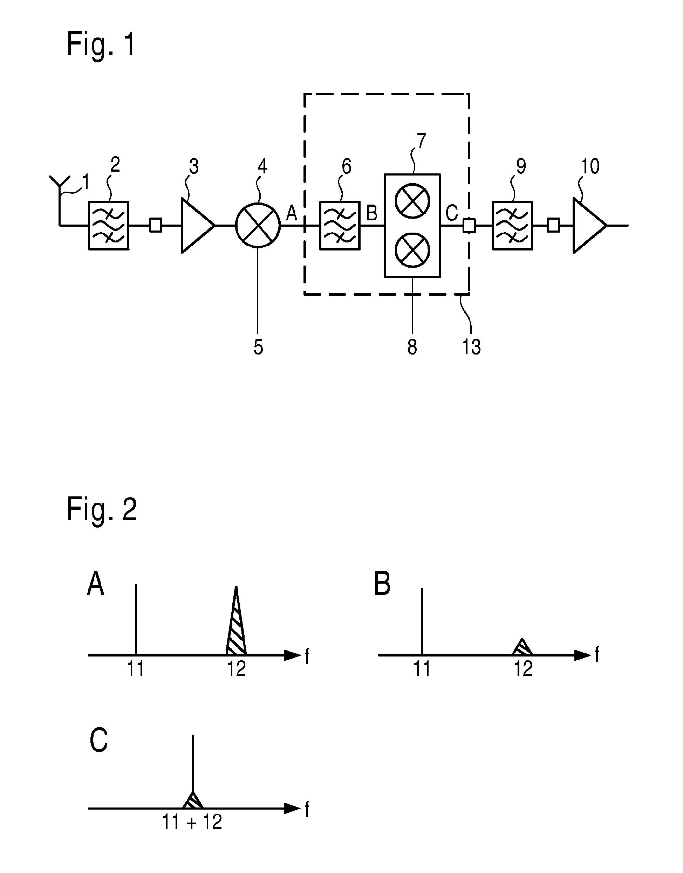

In Figur 1 ist ein schematisches Blockschaltbild des erfmdungsgemäßen Doppel-Superheterodynempfängers dargestellt. Die Empfangssignale werden mittels der Empfangsantenne 1 empfangen und einem Empfangsfilter 2, das vorteilhafterweise als Bandpassfilter ausgeführt ist, zugeführt. In diesem Empfangsfilter 2 wird das zum Empfang relevante Empfangsband ausgefiltert und der nachgeordneten Empfangsschaltung zugeführt. Optional kann am Ausgang des Empfangsfilters 2 ein Verstärker 3 vorgesehen sein, der vorteilhafterweise als rauscharmer Verstärker (LNA: Low Noise Amplifier) ausgeführt sein kann. Das durch den Verstärker 3 verstärkte Empfangssignal wird einem ersten Mischer 4 zugeführt, dem zusätzlich das Signal eines ersten Lokaloszillators 5 zugeführt wird. In diesem ersten Mischer 4 wird das Empfangssignal auf eine erste Zwischenfrequenz heruntergemischt, so dass am Ausgang des ersten Mischers 4 das Frequenzspektrum A, wie es in Figur 2 dargestellt ist, vorhanden ist. Dieses Frequenzspektrum A, wie es in Figur 2 dargestellt ist, weist auf der Frequenzachse f sowohl ein Nutzsignal 11 als auch ein Spiegelsignal 12 auf, wobei das Nutzsignal 11 und das Spiegelsignal 12 unterschiedliche Mittenfrequenzen aufweisen. Dieses Signal wird gemäß Figur 1 dem ersten Zwischenfrequenzfilter 6 zugeführt, das gemeinsam mit dem Spiegelunterdrückungsmischer 7 auf einem gemeinsamen Substrat, dem Empfängerchip 13, ausgeführt sind. Dieser Empfängerchip 13 kann optional auch noch zusätzliche Komponenten der dargestellten Empfängerschaltung aufweisen, jedoch umfasst dieser mindestens das erste Zwischenfrequenzfilter 6 sowie den Spiegelunterdrückungsmischer 7, die elektrisch unmittelbar miteinander verbunden sind. Das Spektrum A gemäß Figur 2 wird gemäß Figur 1 dem ersten Zwischenfrequenzfilter 6 zugeführt, das so ausgelegt ist, dass die Spiegelfrequenz 12 stark gedämpft wird, jedoch das Nutzsignal 11 möglichst wenig Dämpfung erfährt. Das Ausgangssignal dieses ersten Zwischenfrequenzfilters 6 ist in Figur 2 im Frequenzspektrum B dargestellt. Gemäß der beschriebenen Dimensionierung des ersten Zwischenfrequenzfilters 6 sind die Mittenfrequenzen sowohl des Nutzsignals 11 als auch des Spiegelsignals 12 unverändert geblieben, jedoch die Amplitude des Spiegelsignals 12 stark gedämpft worden. Die Amplitude des Nutzsignals 11 hat durch das erste Zwischenfrequenzfilter 6 nur eine möglichst geringe Dämpfung erfahren. Dieses Signal wird gemäß Figur 1 dem Spiegelunterdrückungsmischer 7 zugeführt, dem zusätzlich ein zweites Lokaloszillatorsignal 8 zugeführt wird. Dieser Spiegelunterdrückungsmischer 7 mischt das Empfangssignal B, wobei hierbei das Spiegelsignal 12 mit der Spiegelfrequenz eliminiert wird. Die vollständige Eliminierung des Spiegelsignals ist jedoch nur möglich, wenn die beiden Einzelmischer des Spiegelunterdrückungsmischers 7 exakt identisch ausgeführt sind und die den Mischern zugeführten Signale den hohen Anforderungen bezüglich ihrer Amplituden- und Phasenverhältnisse genügen. Da diese beiden Einzelmischer infolge der Herstellungsprozesse und der Genauigkeiten bei der Herstellung nicht exakt identisch ausführbar sind, sondern lediglich sehr ähnliche Charakteristiken aufweisen, sowie die zugeführten Signale nie ideale Amplituden- und Phasenverhältnisse besitzen, ist eine vollständige Unterdrückung des Spiegelsignals 12 in der Praxis nur schwer möglich. Durch das Vorschalten des ersten Zwischenfrequenzfilters 6 wurde jedoch das Spiegelfrequenzsignal 12 derart vorabgeschwächt, dass am Ausgang des Spiegelunterdrückungsmischers 7 das Spiegelsignal 12 nur noch sehr schwach vorhanden ist. Dieses Ausgangsignal des Spiegelunterdrückungsmischers 7 ist im Frequenzspektrum C der Figur 2 dargestellt. Durch den Spiegelunterdrückungsmischer 7 wurden die Mittenfrequenzen des Nutzsignals 11 sowie des Spiegelsignals 12 auf eine gemeinsame Frequenz umgesetzt, so dass sich das Nutzsignal 11 und das Spiegelsignal 12 überlagern. Infolge der starken Vorabschwächung des Spiegelsignals 12 ist jedoch das Pegelverhältnis des Nutzsignals 11 zum Spiegelsignal 12 ausreichend groß, um eine weitere Verarbeitung durchführen zu können. Das Ausgangssignal des zweiten Mischers 7, der als Spiegelunterdrückungsmischer ausgeführt ist, wird einem zweiten Zwischenfrequenzfilter 9 zugeführt, das das Nutzsignal 11, das mit dem stark abgeschwächten Spiegelsignal 12 überlagert ist, schmalbandig filtert, so dass das Nutzsignal 11 weiter verarbeitet werden kann. Optional kann weiterhin vorgesehen sein, dass das Ausgangssignal des zweiten Zwischenfrequenzfilters 9 einem Ausgangsverstärker 10 zugeführt wird, der das mit dem stark abgeschwächten Spiegelsignal 12 überlagerte Nutzsignal 11 für eine weitere Verarbeitung verstärkt. Durch die gemeinsame monolithische und eng benachbarte Ausführung des ersten Zwischenfrequenzfilters 6 und des Spiegelunterdrückungsmischers 7 auf einem gemeinsamen Substrat ist es möglich, die Spiegelunterdrückung von ca. 30 dB, die ein Spiegelunterdrückungsmischer ohne aufwendigen Abgleich über Prozess- und Temperaturschwankungen erreicht, um einen Wert von größer 15dB zu verbessern, um damit einen höheren Störabstand zwischen dem Nutzsignal 11 und dem Spiegelsignal 12 zu erreichen, um eine weitere Verarbeitung des Nutzsignals 11 ohne Störung durch das Spiegelsignal 12 durchführen zu können.

## Patentansprüche

1. Doppel-Superheterodynempfänger, der ein Empfangsfilter (2), einen ersten Mischer (4), ein erstes Zwischenfrequenzfilter (6), einen zweiten Mischer (7) und ein zweites Zwischenfrequenzfilter (9) aufweist, **dadurch gekennzeichnet, dass** der zweite Mischer (7) ein Spiegelunterdrückungsmischer ist und dass mindestens das erste Zwischenfrequenzfilter (6) und der Spiegelunterdrückungsmischer (7) gemeinsam auf einem Chip (13) monolithisch integriert sind.

2. Empfänger nach Anspruch 1, **dadurch gekennzeichnet, dass** das erste Zwischenfrequenzfilter (6) ein monolithisch integriertes LC-Filter ist.

3. Empfänger nach Anspruch 1 oder 2, **dadurch gekennzeichnet, dass** das erste Zwischenfrequenzfilter (6) so dimensioniert ist, dass die Dämpfung bei der Frequenz des dem Spiegelunterdrückungsmischer zugeführten Nutzsignals (11) möglichst gering ist und dass die Dämpfung bei der Frequenz des dem Spiegelunterdrückungsmischer zugeführten Spiegelsignals (12) möglichst hoch ist.
